# EUROPEAN PATENT APPLICATION

(11) **EP 0 642 160 A1**
(43) Date of publication of application: **08.03.1995**
(21) Application number: 94112819.1
(22) Date of filing: 17.08.1994
(51) Int. Cl.: H01L 23/495

(54) **Semiconductor device with improved support means**

(30) Priority: 07.09.1993 US 116628
(71) Applicant: MOTOROLA, INC., Schaumburg, IL 60196 (US)
(72) Inventor: Berg, Howard M., Scottsdale, Arizona 85260 (US); Ganesan, Sankaranarayanan, Chandler, Arizona 85226 (US); Thomas, Ronald E., Tempe, Arizona 85282 (US)
(74) Representative: Hudson, Peter David

(57) **Abstract**

A semiconductor device (42) with improved support means comprises a support frame having separated frame sections (10,12,14,16) supporting a semiconductor die (18). The various dimensions of the frame sections (10,12,14,16), other than their length, are less than 70 mils. The limited dimensions prevents delamination and cracking of encapsulating molding compound (40). In other configurations, the dimensions may be kept to less than 70 mils by incorporating openings (60,62,90,92) which define the dimensions. The openings and separation of frame sections limits the propagation of any delamination.

## Description

### Background of the Invention

The present invention relates, in general, to semiconductor devices, and more particularly, to semiconductor devices having improved support means.

Leadframes to which semiconductor die are attached during packaging typically include a flag portion which lies below the semiconductor die. The flag portion provides a surface for aligning and attaching the semiconductor die, and for supporting the die during wire bonding to the leads of the leadframe and during molding. Conventionally, the flag of the leadframe comprises a large square area as big as, or bigger than the die which will be attached to it. Such a flag provides very effective support to the die during wire bonding. However, such a flag gives rise to important disadvantages when the leadframe is encapsulated in molding compound.

When a large square flag is encapsulated in molding compound, the molding compound tends to delaminate easily from the flag due to mismatch in thermal expansion of the molding compound relative to the metal flag, and due to moisture induced stresses at metal/molding compound interfaces. The greater the surface area of the flag, the more severe the delamination. The delamination negatively impacts reliability of the device and therefore significantly affects yield and customer acceptance.

A related problem arising from the conventional flag configuration is cracking of the molding compound. The large areas of delamination described above can trap water. During reflow soldering conditions the water turns to steam, creating steam induced bowing of the molding compound below the delaminated area. The steam induced bowing creates great stress at the edges of the flag which can lead to cracking (this condition is known in the industry as "popcorning").

Several approaches have been taken in order to alleviate delamination and molding compound cracking caused by large surface area leadframe flags. Molding compound adheres much better to the bare Silicon of the die than to the metal flag. Consequently, one approach has been to eliminate the flag altogether, providing a flagless leadframe. The flagless leadframes support the semiconductor die only along its very edges and in some cases only at some specific points along the edges. Such a configuration provides inferior support to the die during wirebonding and other packaging processes. Additionally, such a configuration can not be easily adapted to suit various die sizes because the leadframe is designed to meet a particular size die at its very edge.

Another approach has been to provide relatively narrow tie bars extending across the bottom of the semiconductor die. However, the tie bar flag configuration is not particularly suited for eliminating delamination because when delamination begins at any location along a tie bar, it tends to propagate along the entire length of the tie bar.

Consequently, what is needed is a flag configuration which minimizes the amount of molding compound in contact with the flag to minimize delamination and therefore stresses and cracks caused by the delamination. Furthermore, it would be desirable to provide a flag configuration which provides improved support throughout the surface area of the semiconductor die during wirebonding and molding. Additionally, a flag configuration is desirable which inhibits the propagation of any delamination which begins to occur along a portion of the flag. Also, the flag should be suitable for a range of die sizes.

### Summary of the Invention

Briefly stated, the present invention is a semiconductor device with improved support means. Generally, the invention includes a semiconductor die and a support frame under the semiconductor die. The support frame comprises a plurality of independent support sections. The support frame supports the die along at least 75% of its length and 75% of its width.

The invention may alternatively comprise a semiconductor die with a leadframe below the die. The leadframe may include a perforated flag. The perforations in the flag define a rail network comprising rail elements. The width of the rail elements is less than 70 mils.

### Brief Description of the Drawings

FIG. 1 is a bottom view of a semiconductor die supported by a support frame in accordance with one embodiment of the present invention;
FIG. 2 is a cross-sectional side view of the device shown in FIG. 1, further including molding compound encapsulating the device shown in FIG. 1;
FIG. 3 is a bottom view of a semiconductor die supported by a support frame in accordance with another embodiment of the present invention;
FIG. 4 is a top view of a support frame in accordance with another embodiment of the present invention, where the appropriate location of a semiconductor die is indicated; and
FIG. 5 is a semiconductor device support frame in accordance with another embodiment of the present invention.

### Detailed Description of the Drawings

Leadframes for use with semiconductor die typically include a "flag" portion which supports the semiconductor die during wire bonding, molding and other processes, and provides structure for attachment and alignment of the die with respect to the leadframe. The flag, or support frame, in accordance with a preferred embodiment of the present invention, provides several improvements over the conventional semiconductor die support frame.

As discussed in the background section, molding compound adheres fairly well to the semiconductor die, and poorly to the metal of the support frame. Consequently, delamination occurs mostly between the molding compound and the support frame, and not between molding compound and the die. It should be understood that this assumes that the die is very clean at the time it is encapsulated by molding compound. They die may be sufficiently cleaned with the UV/ozone method disclosed in UK Patent application no. GB-A-2261548. The cleanliness of the die may be measured with the water drop angle test disclosed in US Patent No. 5275667, where an angle of 8 degrees is sufficient.

The support frame in accordance with the preferred embodiments of the present invention minimizes the surface area of the support frame, thus limiting the potential for delamination. Nevertheless, the preferred support frame provides the more support than many prior art designs to the semiconductor die required during wire bonding and other packaging processes.

The support frame in accordance with a preferred embodiment provides further improvement in that it comprises independent support sections. When delamination occurs along one of the sections, it is inhibited from propagating through to the other sections. Consequently, delamination can be isolated to a portion of the support frame.

Additionally, the support frame in accordance with the preferred embodiment minimizes cracking of the molding compound. The preferred configuration comprises support frame sections which are less than 70 mils wide. It has been determined that the stresses caused by delamination bowing along an element of less than 70 mils are not enough to cause cracking in the molding compound. Seventy mils has been determined to be the optimum size for the preferred molding compound, Sumitomo S7700, and the preferred chip package which is a thin, small outline package (TSOP) which has 11 mils of molding compound between the bottom of the support frame and the bottom of the overall package. It should be understood, in view of the present disclosure, that even narrower support frame members will be required for poorer quality molding compounds. Additionally, narrower support frame members will be required where there is less molding compound below the support frame. The preferred package is discussed in detail here.

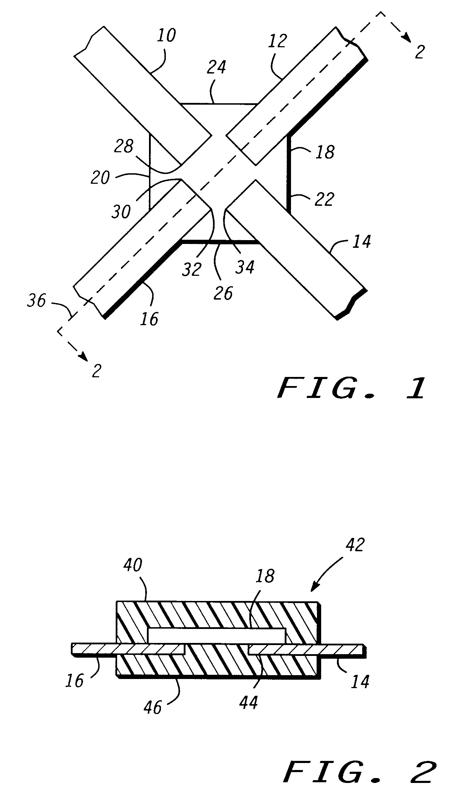

Turning to the figures, FIG. 1 is a bottom view of a semiconductor die supported by a support frame in accordance with one preferred embodiment of the present invention. The support frame comprises separated frame elements which are elongated rails 10, 12, 14 and 16. The support frame lies below semiconductor die 18. It should be understood that the die and support frame are not necessarily drawn to scale, but rather for illustrative purposes.

The support frame comprising the elongated rails is considered the flag of the leadframe. The remainder of the leadframe, including leads which would typically extend inward parallel to the elongated rails, are not shown in order to maintain clarity.

It is important to note that the elongated rails 10, 12, 14 and 16 are independent, and do not connect. This separation of frame rails provides isolation of delamination which may occur along a single element. Any delamination along one of the rails will be unable to propagate to the other rails.

According to the preferred embodiment, the elongated rails have a rail width of less than 70 mils, and preferably about 65 mils. As previously discussed, delamination of the molding compound from a rail having width less than 70 mils does not create stresses sufficient to crack the molding compound of the preferred semiconductor device. The length of the elongated rail members 10, 12, 14 and 16 may, however, be greater than 70 mils. It has been recognized that the stresses that cause mold compound cracking are primarily determined by the shorter dimension of the rail, referred to here as rail width. Consequently, only the width of the elongated rail members are of particular concern.

Semiconductor die 18 has a length between edges 20 and 22, and a width between edges 24 and 26. The length and width of course also define a surface area. The support frame comprising the separated frame sections supports the die along at least 75% of the die length and 75% of the die width. In the preferred embodiment shown in FIG. 1, the support frame supports the semiconductor die along the entire length, except for the short distance between corner 32 of rail 16 and corner 34 of rail 14, that distance being much less than 25% of the die's length. Similarly, the support frame shown in FIG. 1 supports the semiconductor die along the entire width except for the distance between corner 28 of rail 10 and corner 30 of rail 16. Thus, the support frame in accordance with the embodiment of FIG. 1 provides substantial support along the length and width of the semiconductor die, while minimizing the surface area of the support frame which comprises the separated frame sections. More specifically, the preferred support frame covers less than 50% of the surface area of semiconductor die 18. It should be understood, however, that the support required during wire bonding depends on the particular location of the bonding pads. Support is required near each bonding pad. If a particular support frame does not provide sufficient support for every pad, grooves shaped to fit the support frame may be formed in the wire bonding table (heater block). The table will then sufficiently support the die.

FIG. 2 is a cross-sectional side view of the semiconductor device shown in FIG. 1, taken along line 36. FIG. 2 further illustrates molding compound 40 encapsulating semiconductor die 18 and the support frame including rails 14 and 16. The preferred package 42 is a TSOP package. Molding compound 40 comprises Sumitomo S7700 material. Additionally, in the preferred package, the distance between lower surface 44 of the support frame and lower surface 46 of the overall package is 11 mils. The combination of the particular material and the particular thickness of the package below the support frame dictates the sub-70 mil rail width of the preferred device. Molding compounds which crack more easily will, of course, require narrower rail widths. Additionally, as the thickness of the package below the support frame decreases, the rail width must be decreased to prevent cracking.

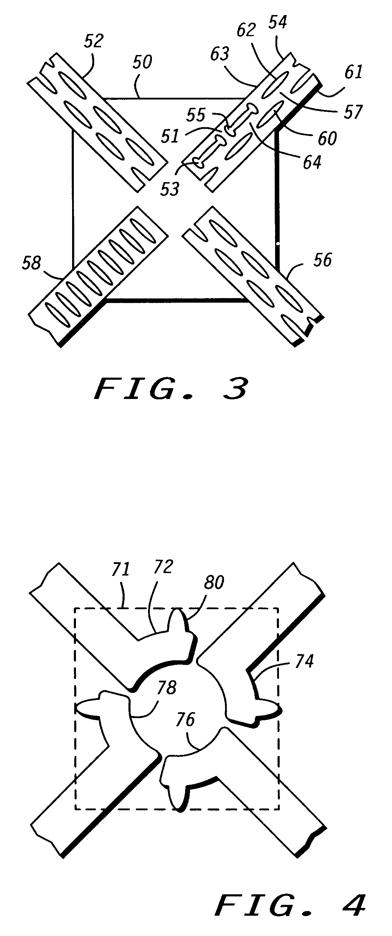

FIG. 3 illustrates alternate embodiments of the support frame structure. Semiconductor die 50 is supported by a support frame comprising independent support sections (rails) 52, 54, 56 and 58. Rails 52, 54 and 56 include openings, represented by elongated slots 60 and 62. In the embodiment shown in FIG. 3, the rails of the support frame may be wider than the required 70 mils. However, the rails are provided with openings, such as elongated slots 60, 62, to define the sub-70 mil dimension required. More specifically, the distance across rail 54, between slot 60 and slot 62 is less than 70 mils, and preferably about 65 mils. Furthermore, the distance from slot 60 to edge 61 is about 65 mils, and the distance from slot 62 to edge 63 is about 65 mils. Consequently, there are no width dimensions of the rail which is greater than 70 mils. As discussed previously, the length of the portions of rail 54, such as portion 64 running through the center of the slots toward the center of the die, may be greater than 70 mils because delamination along the length of such an elongated rail does not tend to cause cracking in the molding compound.

A particular concern is illustrated when considering the rail portions between the ends of the slots, for example portion 51. If portion 51 delaminates then the steam induced bowing of the molding compound will concentrate the stress at the tips of slots 53 and 55. All of the stress will be concentrated in a relatively small amount of molding compound. Depending on the type of molding compound and dimensions of a particular application, the high concentration of stress could lead to cracking. This can be contrasted with a delamination which might occur between slots, at portion 57, for example. There, stress would be distributed along the entire edge of a slot. The distribution of the stress will reduce the possibility of cracking.

Consequently, slots 53 and 55 have been given dumbbell shaped lobes at their ends. The end lobes are wider than the width of the slot. The lobes provide a longer linear portion to meet the delamination, thus distributing stress. This example may be extended a more general design rule. That is, the rails and slots should be designed so that the smallest portion of a slot meets the shortest length of any potential delamination, because shorter delaminations create less stress. A simple design would place the tips of slots very close together. Alternatively, every slot may be given a dumbbell shape.

The discussed design rule can be applied as illustrated by rail 58. Rail 58 has slots perpendicular to the length of the rail. These slots have their smallest potion, their tips, facing a short path of delamination, the distance from the tip to the edge of the rail.

FIG. 4 illustrates yet another embodiment of a support frame comprising separated frame sections which are elongated rails with widths less than 70 mils. More specifically, the support frame illustrated in FIG. 4 comprises elongated rail portions 72, 74, 76 and 78. One notable distinction of the support frame shown in FIG. 4 is that the rails taken together form a circular shape. Additionally, the rails each include an extending portion represented by extending portion 80. Extending portion 80 is generally perpendicular to rail 72 at the point where portion 80 extends from the rail.

The configuration of the support frame illustrated in FIG. 4 is understood to provide particularly good support for semiconductor die, while minimizing the overall surface area of the support frame. The appropriate location for a semiconductor die is indicated by line 71. The perpendicular extending portions, including portion 80, extend to the very edge of the die to provide support there. Furthermore, the overall circular configuration of the support frame distributes support along a curved edge rather than along a straight edge which might be conducive to die cracking.

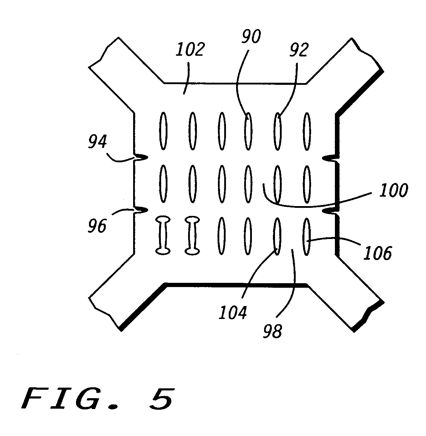

FIG. 5 illustrates the support frame of a semiconductor die in accordance with another embodiment of the present invention. The support frame of FIG. 5 is generally similar to rails 52, 54 and 56 of the frame illustrated in FIG. 3. That is, openings, or perforations, are formed in the support frame in order to provide the sub-70 mil dimensions which prevent cracking of the molding compound if delamination occurs. Specifically, elongated slots represented by slots 90 and 92 are provided to define sub-70 mil dimensions between slots, and between slots and edges of the support frame. The tips of the slots are preferably very close to each other to make the delamination path between the tips very short. Additionally some or all slots may be dumbbell shapes, as described with reference to FIG. 3.

The slots (e.g., 90, 92) define a rail network. The rail network comprises rail elements represented by elements 98, 100 and 102. Elements 98, 100 and 102 are considered to have a length extending entirely across the support frame, and a width defined by the separation of the elongated slots. For example, the width of rail element 98 is defined by the distance between slots 104 and 106, as well as the other slots along its length. Similarly, the width of rail element 100 is defined by the distance between slot 90 and slot 92. Thus, a support frame is provided, similar to the previously discussed support frames, wherein the dimensions of the supporting members remains less than 70 mils.

As previously discussed, the width of the rails is the important dimension with regard to controlling cracking. However, it should be understood that slots could be provided at right angles to those shown in order to define sub-70 mil dimensions in both directions, throughout the support frame. Additionally, notches represented by notches 94 and 96 are optionally provided at the perimeter of the support frame in order to define sub-70 mil lengths along some of the edges.

The perforations in the support frame not only define the sub-70 mil dimension which prevents cracking, but also inhibit the propagation of delamination. More specifically, molding compound fills the perforations and attaches to the semiconductor die (not shown). Delamination which begins propagating toward one of the perforations will be inhibited by the molding compound which is more firmly attached to the semiconductor die, through the perforation.

By now, it should be appreciated that a semiconductor device with improved support means has been provided which minimizes the amount of molding compound in contact with the support frame of the device. The configuration of the support frame minimizes delamination, as well as stresses and cracks caused by the delamination. Furthermore, the frame provides improved support throughout the surface area of the semiconductor die during wirebonding, molding and other processes. Additionally, the frame inhibits the propagation of any delamination which begins to occur along a portion of the frame. Also, the frame is suitable for a range of die sizes.

## Claims

1. A semiconductor device comprising:
a semiconductor die (18) comprising a length and a width;
a support frame comprising a plurality of separated frame sections (10, 12, 14 16), each separated frame section having at least one dimension which is less than 70 mils; and
wherein the semiconductor die is supported by the support frame along at least 75% of the length and along at least 75% of the width.

2. The device of claim 1, wherein at least one of the separated frame sections (72) comprises an elongated rail portion and an extending portion (80) extending substantially perpendicular to the elongated rail portion (72).

3. The device of claim 1, wherein the separated frame sections comprise elongated rails (52, 54, 56, 58), each having a rail width.

4. A semiconductor device comprising:
a semiconductor die (18) having a surface area, and a length and a width;
a support frame under the semiconductor die, the support frame comprising a plurality of independent support sections (10, 12, 14, 16); and
wherein the support frame supports the semiconductor die (18) along at least 75% of the length and at least 75% of the width, and wherein the support frame covers less than 50% of the surface area of the semiconductor die.

5. The device of claim 4, wherein the independent support sections comprise elongated members (10, 12, 14, 16) having a width less than 70 mils.

6. A semiconductor device comprising:
a semiconductor die (18); and
a leadframe adjacent the semiconductor die, the leadframe comprising a perforated flag comprising perforations (90,92), the perforations comprising slots having tips which comprise enlarged lobes.

7. The device of claim 6, wherein the perforations define a rail network and the rail network comprises a plurality of rail elements (98, 100, 102), each having a length and a width, the width being less than 70 mils.

8. A method for making a semiconductor device comprising:
forming a plurality of perforations (90, 92, 104, 106) in a flag of a leadframe to define a rail network, the rail network comprising rail elements (98, 100, 102), each having a length and a width, the width being less than 70 mils;
positioning a semiconductor die above the leadframe; and
encapsulating the semiconductor die and the flag in molding compound.

9. The method of claim 8, wherein the step of forming comprises forming slots having tips which comprise enlarged lobes.
